(19) Europäisches Patentamt
European Patent Office
Office européen des brevets

(11) **EP 4 421 866 A1**

(12) **EUROPEAN PATENT APPLICATION**

(43) Date of publication:
**28.08.2024 Bulletin 2024/35**

(21) Application number: **23158383.2**

(22) Date of filing: **24.02.2023**

(51) International Patent Classification (IPC):
**H01L 23/552** (2006.01)   **H01L 23/31** (2006.01)
**H01L 23/36** (2006.01)

(52) Cooperative Patent Classification (CPC):
**H01L 23/552; H01L 23/36;** H01L 23/3128;
H01L 23/49816

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Infineon Technologies AG
85579 Neubiberg (DE)**

(72) Inventors:
• **KORNPROBST, Simon
83071 Stephanskirchen (DE)**
• **ERDÖL, Tuncay
82008 Unterhaching (DE)**
• **HARTNER, Walter
93077 Bad Abbach (DE)**

(74) Representative: **Infineon Patent Department
Intellectual Property
Infineon Technologies AG
Postfach 22 16 44
80506 München (DE)**

(54) **RADIO FREQUENCY SEMICONDUCTOR DEVICE AND METHOD FOR FABRICATING A RADIO FREQUENCY SEMICONDUCTOR DEVICE**

(57)     A radio frequency (RF) semiconductor device to process RF signals in an operating frequency range is provided which comprises, a semiconductor chip comprising a first surface, a second surface opposite to the first surface and sidewalls, the semiconductor chip comprising an active chip area, a redistribution layer comprising a first side, the first side of the redistribution layer facing the first surface of the semiconductor chip, an RF absorption layer external to the active chip area, wherein the RF absorption layer comprises a doped semiconductor material.

Figure 6

## Description

### TECHNICAL FIELD

The present disclosure relates to a radio frequency semiconductor device and in particular to a radio frequency semiconductor device with high loss material. In addition, the present disclosure relates to method of manufacturing such devices.

### BACKGROUND

In radio frequency (RF) semiconductor devices, elimination of undesired radiation is a crucial factor for reliable device performance. The undesirable radiation may originate from electrical interconnections of the RF semiconductor device or from external radiation sources. The undesired radiation lowers the quality of an RF signal to be processed by the RF semiconductor device. The current paths in the device are impacted by undesired radiation, increasing the cross-communication between the different routes of the circuits and electromagnetic interference (EMI).

Mold compounds applied in the RF semiconductor device packaging usually exhibit low-loss properties such that the RF signal can propagate without significant attenuation. The RF signals may be reflected at the mold compound-air interface transferring energy back in the RF semiconductor device. This may cause failure or poor performance of the RF device.

Accordingly, it is an object of the present application to provide a concept for an RF semiconductor device in which impact of undesired radiation is reduced. This object is solved by a radio frequency semiconductor device according to claim 1 and a method of fabricating a radio frequency semiconductor device according to claim 14.

### SUMMARY

According to an example of the invention, a radio frequency (RF) semiconductor device to process RF signals in an operating frequency range comprises a semiconductor chip comprising a first surface, a second surface opposite to the first surface and sidewalls, wherein the semiconductor chip comprises an active chip area. The RF semiconductor device comprises a redistribution layer comprising a first side, the first side of the redistribution layer facing the first surface of the semiconductor chip. The RF semiconductor device further comprises an RF absorption layer external to the active chip area, wherein the RF absorption layer comprises a doped semiconductor material such that the dissipating factor of the RF absorption layer is equal or greater than 0.1 in the operating frequency range.

According to an example of the invention a method for fabricating a radio frequency (RF) semiconductor device to process RF signals in an operating frequency range comprises:

- providing a semiconductor chip comprising a first surface, a second surface opposite to the first surface and sidewalls, the semiconductor chip comprising an active chip area;
- providing a redistribution layer comprising a first side, the first side of the redistribution layer facing the first surface of the semiconductor chip;
- disposing an RF absorption layer external to the active chip area, wherein the RF absorption layer comprises a doped semiconductor material such that the dissipating factor of the RF absorption layer is equal or greater than 0.1 in the operating frequency range.

### BRIEF DESCRIPTION OF THE DRAWINGS

The present disclosure is illustrated by way of example, and not by way of limitation, in the figures of the accompanying drawings in which like reference numerals refer to similar or identical elements. The elements of the drawings are not necessarily to scale relative to each other. The features of the various illustrated examples can be combined unless they exclude each other.

Fig. 1 schematically illustrate a cross-sectional view of a radio frequency (RF) semiconductor device.
Fig. 2 schematically illustrate a cross-sectional view of a RF semiconductor device.
Fig. 3 schematically illustrate a cross-sectional view of a RF semiconductor device.
Fig. 4 schematically illustrate a cross-sectional view of a RF semiconductor device.
Fig. 5 schematically illustrate a cross-sectional view of a RF semiconductor device.
Fig. 6 schematically illustrate a cross-sectional view of a RF semiconductor device.
Fig. 7 schematically illustrate a cross-sectional view of a RF semiconductor device.
Fig. 8 shows an experimental measurement of dielectric constant.

### DETAILED DESCRIPTION

In the following description, directional terminology, such as "top", "bottom", "upper", "lower" "front", "back" etc., is used with reference to the orientation of figures being described. The components of the disclosure can be positioned in a number of different orientations, the directional terminology is used for purposes of illustration and is in no way limiting.

Furthermore, to the extent that the terms "include", "have", "with" or other variants thereof are used in either the detailed description or the claims, such terms are intended to be inclusive in a manner similar to the term "comprise". The terms "coupled" and "connected", along with derivatives thereof may be used. It should be understood that these terms may be used to indicate that two elements co-operate or interact with each other regardless of whether they are in direct physical or electrical contact, or they are not in direct contact with each other; intervening elements or layers may be provided between the "bonded", "attached", or "connected" elements.

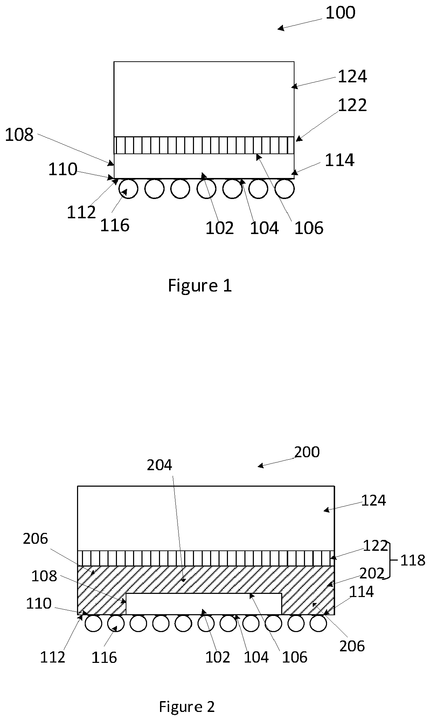

Figure 1 shows a cross sectional view of a radio frequency (RF) semiconductor device 100. The RF semiconductor device 100 has a semiconductor chip 102 operating in a predetermined frequency range such as a millimeter-wave frequency range, for example in a first frequency range from 40 GHz to 500 GHz or in a second frequency range from 50 GHz to 250 GHz. In some examples, the semiconductor chip 102 may correspond to a radar chip and may be used as a transmitter, a receiver, a sensor, a detector etc. In other examples the semiconductor chip 102 may be a 5G or 6G communication chip, a high data transfer communication system, wireless backhaul systems of body scanning systems for security.

The semiconductor chip 102 has a first surface 104, a second surface 106 opposite to the first surface 104 and sidewalls 108. The first surface 104 and the second surface 106 may be referred to as a first main surface and second main surface. An active chip area having transistors and other circuit elements is provided in the semiconductor chip 102. The active chip area may be capable of generating RF signals, processing RF signals, and analyzing RF signals and other signals.

The first surface 104 of the semiconductor chip 102 is arranged on a first side 114 of a redistribution layer 110 and an electrical contact is established between the semiconductor chip 102 and electrically conductive structures of the redistribution layer. For example, the electrical contact may be formed by a bond pad which may be made of aluminum and/or copper. This allows an RF signal to be transmitted from the semiconductor chip 102 to the electrical contacts and/or vice-versa. In the implementation of Figure. 1, the RF semiconductor device 100 may correspond to a wafer level package.

The redistribution layer 110 may have one or more electrically conductive structures in form of metal lines or metal planes, running parallel to the first surface 104 of the semiconductor chip 102. The electrically conductive structures route the electric current in the RF semiconductor device 100 and are electrically isolated from each other by a dielectric material. The conductive structures may be made of aluminum, copper or a copper alloy. The dielectric material may comprise an oxide or a nitride.

The redistribution layer 110 has a second side 112 opposite to the first side 114. A plurality of solder balls 116 is arranged on the second side 112 of the redistribution layer 110. Accordingly, the redistribution layer 110 establishes the electrical connection between the solder balls 116 and the semiconductor chip 102. A printed circuit board (PCB) which is not shown in Figure 1 may be electrically and mechanically mounted to the solder balls 116. The solder balls 116 may comprise at least one of Sn, Ag, or Cu. The solder balls 116 may have diameters in a range between 200 and 400 μm and pitches in a range between of 400 and 600 μm. In some examples, Flip-Chip BGAs (Ball Grid Arrays) or Wirebond-BGA may be used for establishing the electrical and mechanical connection to the PCB.

An RF absorption layer 122 is arranged external to the active chip area, such that the RF absorption layer 122 covers and is in contact with the second surface 106 of the semiconductor chip 102. The RF absorption layer 122 can be considered as part of the package for the semiconductor chip 102. The RF absorption layer 122 comprises a doped semiconductor material having (i) an electrical resistivity in a range of 1-100 ohm-cm (ii) a real part of a dielectric constant in a range of 5-15 (iii) a dissipation factor or loss tangent greater than or equal to 0.1, in the operating frequency range. The dissipation factor ($D_f$) or loss tangent ($\tan(\delta)$) of the RF absorption layer 122 is defined as

$$D_f = \tan(\delta) = \frac{\omega \varepsilon_0 \, \varepsilon_r'' + \sigma}{\omega \varepsilon_0 \, \varepsilon_r'}$$

Where, $\omega$ is the angular frequency, $\sigma$ is the electrical conductivity, $\varepsilon_0$ is the vacuum permittivity, $\varepsilon_r'$ is the real part of relative permittivity of the RF absorption layer 122 and

$$\varepsilon_r''$$

is the imaginary part of relative permittivity of the RF absorption layer 122. The real part of the relative permittivity $\left( \varepsilon_r' \right)$ of the RF absorption layer 122 is also referred as $D_k$.

In some examples, the RF absorption layer 122 may comprise a doped semiconductor filler material wherein the doped semiconductor filler material further comprises doped semiconductor particles. In some examples, the semiconductor may be silicon and the dopant may be a p-dopant such as boron. A particle size of the doped semiconductor particles in the semiconductor filler material may be less than 100 μm. In some examples, the maximum dimension in all space directions of each of the particles is less than 100 μm. In some examples, a mean value of the maximum dimension of each particle is less than 100 μm. The semiconductor particles comprise at least one of p-doped crystal semiconductor particles, p-doped amorphous semiconductor particles or p-doped semiconductor oxide particles. A shape of the semiconductor particle may be spherical or of any other regular or irregular shape. The RF absorption layer 122 comprises the doped semiconductor filler material with a volume of at least 45% of the total RF absorption layer 122 volume and a polymer mold material with a volume of 55% or less of the total RF absorption layer 122 volume. The mold materials may be thermoset polymers, thermoplastic polymers or elastomer polymers.

A metal plate 124 may be attached to the RF absorption layer 122 on a side opposite to a side facing the redistribution layer 110. The metal plate 124 allows an efficient heat removal from the semiconductor chip 102 via the second surface 106.

With the introduction of the RF absorption layer 122 into a semiconductor package which uses doped semiconductor material to achieve an absorption of radiation, a new concept is introduced which allows an efficient, cost effective and configurable absorption concept for packaged RF semiconductor devices. In particular, with a proper selection the doping material, the doping concentration, or the volume of the semiconductor material within the layer, the RF absorption layer 122 can be tailored in a flexible manner as a high loss layer such that the dissipating factor of the RF absorption layer 122 is equal or greater than 0.1 in the operating frequency range. The new concept is therefore inexpensive and highly flexible since an adaption of the absorption properties can be achieved by varying one of the above-mentioned properties of the semiconductor material. This makes the concept especially suitable for upcoming technologies and the semiconductor chip 102 scaling in which more and more functionalities are integrated since the absorption can be easily varied and adapted for example in order to take into account the required operation frequency, the size or design of the RF semiconductor device 100, the routing of RF lines within the RF semiconductor device 100 or the package type used. The concept can be used for single-chip RF devices or multi-chip RF devices in which multiple semiconductor chips are arranged above or lateral to each other within a semiconductor package. The new concept thereby allows improving an electrical performance of the RF semiconductor device 100, for example by reducing channel-to-channel isolation and improving the robustness of the RF semiconductor device 100 with respect to reflecting materials or signal sources in the surrounding.

Furthermore, the new concept is well-suited for packages in which a metal plate 124 is arranged for heat removal as described above. By providing the above described RF absorption layer 122, reflections from the metal plate 124 back into the semiconductor chip 102 can be significantly reduced allowing a significant improvement of the performance even under such conditions.

Using the doped semiconductor material as a filler material in a polymer mold material as described above allows using molding techniques in order to manufacture the RF absorption layer 122. This enables the provision of the RF absorption layer 122 in any shape. While the RF absorption layer 122 is shown in the Figure 1 in a planar shape it is to be understood that other shapes can be easily manufactured using molding techniques.

The new concept is further well-suited for fan-out packages where the RF signals are in the fan-out area significantly influenced by the dielectric properties of the mold material and a need exists to obtain low-loss properties of the semiconductor package in this area so that the RF signals are allowed to propagate without significant attenuation. The described concept allows therefore to provide low loss mold material in areas of signal propagation and the RF absorption layer 122 as a high loss material in areas where radiation absorption is advantageous as will be described with respect to Figure 2.

Figure 2 shows an example of an RF semiconductor device 200 which may include some or all features of the RF semiconductor device 100 of Figure 1. The RF semiconductor device 200 additionally comprises a chip package 118. A part of the semiconductor chip 102 and a part of the first side 114 of the redistribution layer 110 is encapsulated by the chip package 118. The redistribution layer 110 may at least partially extend over the first surface 104 of the semiconductor chip 102 such that the semiconductor chip 102 has a smaller surface area than the redistribution layer 110. The area of the redistribution layer 110 not covered by the semiconductor chip 102 is also referred as a fan-out area. The RF semiconductor device 200 may be referred as a fan-out device or a fan-out package. The fan-out package may be manufactured for example by an eWLB (embedded Wafer Level Ball Grid Array) process.

The chip package 118 in addition to the RF absorption layer 122, has an encapsulation material 202.

The dissipation factor or loss tangent of the encapsulation material 202 is less than 0.1, such that the encapsulation material 202 is a low-loss material in the operating frequency range. The low-loss properties of the encapsulation material 202 decreases the attenuation of the RF signal to be processed by the RF semiconductor device 200 in the fan-out area. The encapsulation material 202 may be epoxy, filled epoxy, glass fiber filled epoxy, thermoset polymers, thermoplastic polymers, or elastomer polymers,

In the RF semiconductor device 200, the chip package 118 encapsulates the semiconductor chip 102 and parts of the redistribution layer 110. In particular, the encapsulation material 202 is arranged between the RF absorption layer 122 and the first side 114 of the redistribution layer 110. The encapsulation material 202 covers and is in contact with the sidewalls 108 and second surface 106 of the semiconductor chip 102 and the parts of the first side 114 of the redistribution layer 110. As described above, a metal plate 124 is attached to the chip package 118 on a side opposite to a side facing the redistribution layer 110.

In some examples the RF semiconductor device 200 can be manufactured using a multi-mold process. In a first molding step, the low-loss encapsulation material 202 is formed. In a second molding step following the first molding step, the RF absorption layer 122 is formed for example directly on the low-loss encapsulation material 122.

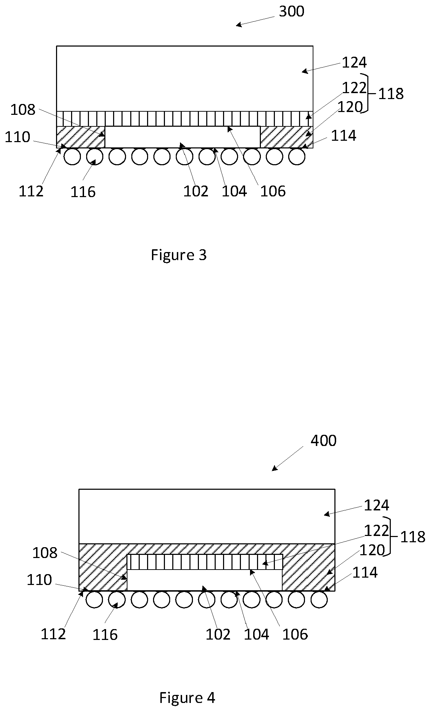

Figure 3 shows an RF semiconductor device 300 which may include some or all features of the RF semiconductor device 200 of Figure 2. The RF absorption layer 122 covers and is in contact with the second surface 106 of the semiconductor chip 102. The RF absorption layer 122 extends beyond the second surface 106 of the semiconductor chip 102. The encapsulation material 202 is filled between the RF absorption layer 122 and the redistribution layer 110 such that the encapsulation material 202 covers and is in contact with the sidewalls 108 of the semiconductor chip 102, the parts of the first side 114 of the redistribution layer 110. In other words, in a first area 204, the semiconductor chip 102 is between the RF absorption layer 122 and the redistribution layer 110 while, in a second area 206, the encapsulation material 202 is between the RF absorption layer 122 and the redistribution layer 110. In some examples the second area corresponds to the fan-out area.

Figure 4 shows an RF semiconductor device 400 which may include some or all features of the RF semiconductor device 200 of Figure 2. The RF absorption layer 122 covers and is in contact with the second surface 106 of the semiconductor chip 102. The encapsulation material 202 covers and is in contact with the sidewalls 108 of the semiconductor chip 102, the parts of the first side 114 of the redistribution layer 110 and the RF absorption layer 122 covering the second surface 106 of the semiconductor chip 102. A material layer between the RF absorption layer 122 and the second surface 106 of the semiconductor chip may be applied as an adhesion layer.

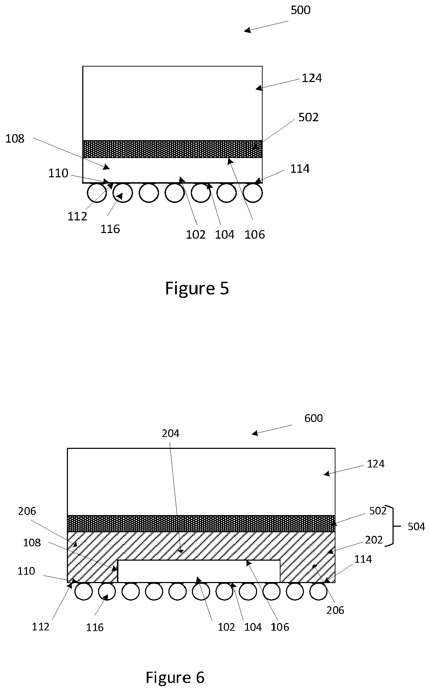

Figure 5 shows an RF semiconductor device 500 which may include some or all features of the RF semiconductor device 100 of Figure 1. In Figure 5, the RF absorption layer 502 is a doped semiconductor layer such as a bulk semiconductor layer. In an example, the RF absorption layer 502 is a p-doped silicon layer having (i) an electrical resistivity in a range of 1-100 ohm-cm (ii) a real part of a dielectric constant in a range of 5-15 (iii) a dissipation factor or loss tangent greater than or equal to 0.1, in the operating frequency range.

Similar to Figure 1, the RF absorption layer 502 shown in Figure 5 is disposed on the second surface 106 of the semiconductor chip 102 and a metal plate 124 is provided on the RF absorption layer 502.

Figure 6 shows a RF semiconductor device 600 which may include some or all features of the RF semiconductor device 500 of Figure 2 or Figure 5. The RF semiconductor device 600 comprises a chip package 504. The chip package 504 encapsulates the semiconductor chip 102 and parts of the redistribution layer 110. In particular, the encapsulation material 202 is arranged between the RF absorption layer 502 and the first side 114 of the redistribution layer 110. The encapsulation material 202 covers and is in contact with the sidewalls 108 and second surface 106 of the semiconductor chip 102 and the parts of the first side 114 of the redistribution layer 110. Similar to Figure 5, the RF absorption layer 502 is a doped bulk semiconductor layer.

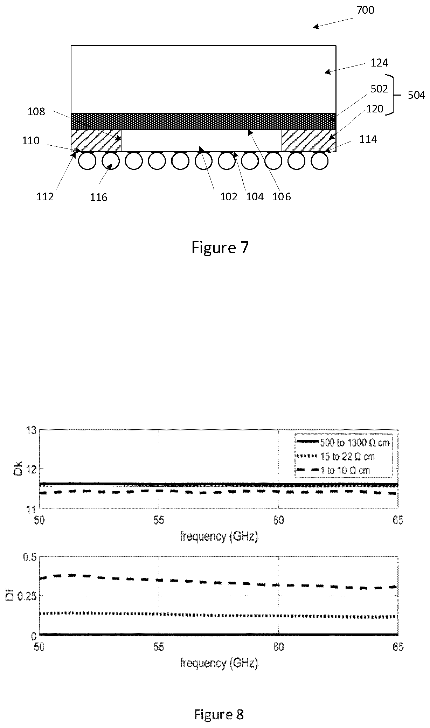

Figure 7 shows a RF semiconductor device 700 which may include some or all features of the RF semiconductor device 600 of Figure 3 or Figure 6. The RF absorption layer 502 covers and is in contact with the second surface 106 of the semiconductor chip 102. The RF absorption layer 502 extends beyond the second surface 106 of the semiconductor chip 102. The encapsulation material 202 is filled between the RF absorption layer 502 and the redistribution layer 110 such that the encapsulation material 202 covers and is in contact with the sidewalls 108 of the semiconductor chip 102, the parts of the first side 114 of the redistribution layer 110.

In the above-described examples, RF absorption layers 122 and 502 have been described utilizing doped semiconductor material as semiconductor packaging material to allow in-package absorption of radiation. The RF absorption layers 122 and 502 comprise doped semiconductor as filler material particles or as a semiconductor layer formed as one piece of semiconductor material. The proposed concept allows the tuning of RF properties to achieve a high-loss at mm-wave frequencies. Various parameters such as resistivity, doping type and crystal orientation may be taken into account to tune the RF absorption layer 122 and 502 to obtain the desired loss properties. Investigations have been made for doped silicon in various configurations. Results thereof will be discussed with respect to Figure 8.

Figure 8 shows a real part of the relative permittivity ($D_k$) and dissipation factor ($D_f$) or loss tangent ($\tan(\delta)$) of the dielectric constant for silicon material of different resistivities range of 1-10 ohm-cm, 15-22 ohm-cm and 500 to 1300 ohm-cm having a 100 crystal orientation and p-type boron-doping. Figure 8 shows the values between 50 GHz and 65 GHz.

As previously described, dissipation factor ($D_f$) or loss tangent ($\tan(\delta)$) of the RF absorption layer 122, 502 is defined as

$$D_f = \tan(\delta) = \frac{\omega \varepsilon_0 \, \varepsilon_r'' + \sigma}{\omega \varepsilon_0 \, \varepsilon_r'}$$

Where, $\omega$ is the angular frequency, $\sigma$ is the electrical conductivity, $\varepsilon_0$ is the vacuum permittivity, $\varepsilon_r'$ is the real part of relative permittivity of the RF absorption layer 122 and 502 and

$$\varepsilon_r'$$

is the imaginary part of relative permittivity of the RF absorption layer 122 and 502. The real part of the relative permittivity $(\varepsilon_r')$ of the RF absorption layer 122 and 502 is also referred as $D_k$.

It can be noted that the higher the value of $D_f$ and the lower the value of $D_k$, the higher the dissipation factor.

In general, the dielectric properties of different p-doped Si show a low frequency dependency in the addressed frequency range at mm-Wave frequencies. As can be seen from Figure 8, the $D_k$ values for different doping levels between 1 ohm-cm up to 1300 ohm-cm are all between in the range between 11 and 12. At the same time, the dissipation factor $D_f$ is strongly influenced by the doping level which tunes the conductivity of the RF absorption layer. While a resistivity value between 500 and 1300 ohm-cm results in a very low loss material in the given frequency range, and the behavior is very similar to undoped silicon, an increasing doping level decreases the resistivity of the RF absorption layer and therefore high absorption can be achieved. For example, a resistivity value of 1 to 10 ohm-cm equals to a dissipation factor $D_f$ of approximately 0.3 with the given characterization results.

Increasing the real-part of a relative permittivity $D_k$ value lowers the dissipation factor $D_f$ for a given resistivity of the RF absorption layer. Table 1 below shows a number of values of dissipation factor $D_f$ for specific resistivity values and real-part of a relative permittivity $D_k$ values. In general, any combination of $D_k$ values and resistivity values which achieves a dissipation factor $D_f$ to be greater than 0.1 can be considered as a high-loss material for the RF absorption layer.

*Table 1*

|  | Dk-8 | Dk-11.5 | Dk-15 |
| --- | --- | --- | --- |
| 0.1ohm-cm | 37.45 | 26.05 | 19.97 |
| 1ohm-cm | 3.74 | 2.61 | 2 |
| 10ohm-cm | 0.37 | 0.26 | 0.2 |
| 15ohm-cm | 0.25 | 0.17 | 0.13 |
| 22ohm-cm | 0.17 | 0.12 | 0.09 |
| 500ohm-cm | 0.01 | 0.01 | 0 |
| 1300ohm-cm | 0 | 0 | 0 |

In general, resistivities from 1 to 100 ohm-cm have been shown to obtain high loss behavior. Furthermore, the crystal orientation is an aspect having an impact on the loss behavior. In Fig. 8 the dielectric properties are shown for a 100 crystal orientation and an incident field perpendicular to the sample which can be considered as a doped wafer with a thickness less than 1 mm. In reality however, RF signals will propagate at different angles through the material. Differences of the dielectric properties between 100 and 111 orientations have been observed with the loss for the example of Fig. 8 being even higher for the 111 crystal orientation compared to the 100 crystal orientation.

The following examples pertain to further aspects of the disclosure:

Example 1 discloses a radio frequency (RF) semiconductor device to process RF signals in an operating frequency range comprising, a semiconductor chip comprising a first surface, a second surface opposite to the first surface and sidewalls, the semiconductor chip comprising an active chip area, a redistribution layer comprising a first side, the first side of the redistribution layer facing the first surface of the semiconductor chip, an RF absorption layer external to the active chip area, wherein the RF absorption layer comprises a doped semiconductor material such that the dissipating factor of the RF absorption layer is equal or greater than 0.1 in the operating frequency range.

Example 2 discloses the RF semiconductor device according to example 1, wherein the RF absorption layer is disposed on the semiconductor chip outside of the active chip area.

Example 3 discloses the RF semiconductor device according to example 1, further comprising a chip package disposed over the second surface of the semiconductor chip, wherein the chip package comprises the RF absorption layer.

Example 4 discloses the RF semiconductor device according to example 3, wherein the chip package comprises in addition to the RF absorption layer an encapsulation material, wherein sidewalls of the semiconductor chip and a part of the first side of the redistribution layer are encapsulated by the encapsulation material, wherein the encapsulation material comprises a dissipating factor of less than 0.1 in the operating frequency range.

Example 5 discloses the RF semiconductor device according to example 1, wherein a plurality of solder balls is arranged on a second side of the redistribution layer opposite to the first side to mechanically and electrically connect the RF device to a printed circuit board.

Example 6 discloses the RF semiconductor device according to example 1, wherein the RF absorption layer comprises a doped semiconductor filler material with a volume of at least 45%.

Example 7 discloses the RF semiconductor device according to example 6, wherein the RF absorption layer comprises a polymer mold material with a volume of 55 % or less.

Example 8 discloses the RF semiconductor device according to example 6, wherein the doped semiconductor filler material comprises doped semiconductor particles, wherein the semiconductor filler material comprises:

- a particle size of the doped semiconductor particle is less than 100 $\mu$m, wherein the semiconductor particles comprise at least one of p-doped crystal semiconductor particles, p-doped amorphous semiconductor particles or p-doped semiconductor oxide particles;
- an electrical resistivity in a range of 1 to 100 ohm-cm; and
- a real part of a dielectric constant is in range of 5 to 15.

Example 9 discloses the RF semiconductor device according to example 1, wherein the RF absorption layer comprises:

- a p-doped silicon layer, wherein an electrical resistivity of the p-doped layer is in range of 1 to 100 ohm cm; and
- a real-part of a dielectric constant is in a range of 5 to15.

Example 10 discloses the RF semiconductor device according to example 1 to 9, wherein an encapsulation material is arranged between the RF absorption layer and the first side of the redistribution layer, wherein the encapsulation material covers and is in contact with the sidewalls and second surface of the semiconductor chip and the first side of the redistribution layer.

Example 11 discloses the RF semiconductor device according to example 1 to 9, wherein the encapsulation material covers and is in contact with the side walls of the semiconductor chip and the first side of the redistribution layer, wherein the RF absorption layer covers and is in contact with the second surface of the semiconductor chip and the encapsulation material covering the first side of the redistribution layer.

Example 12 discloses the RF semiconductor device according to example 1 to 9, wherein the RF absorption layer covers and is in contact with the second surface of the semiconductor chip, wherein the encapsulation material covers and is in contact with the sidewalls of the semiconductor chip, the first side of the redistribution layer and the RF absorption layer covering the second surface of the semiconductor chip.

Example 13 discloses the RF semiconductor device according to example 1, wherein a metal plate is attached to the chip package, at chip package -air interface lateral to the second surface of the semiconductor chip.

Example 14 discloses a method for fabricating a radio frequency (RF) semiconductor device to process RF signals in an operating frequency range comprises:

- providing a semiconductor chip comprising a first surface, a second surface opposite to the first surface and sidewalls, the semiconductor chip comprising an active chip area;
- providing a redistribution layer comprising a first side, the first side of the redistribution layer facing the first surface of the semiconductor chip;
- disposing an RF absorption layer external to the active chip area, wherein the RF absorption layer comprises a doped semiconductor material such that the dissipating factor of the RF absorption layer is equal or greater than 0.1 in the operating frequency range.

## Claims

1. A radio frequency (RF) semiconductor device (100) to process RF signals in an operating frequency range comprising:

   - a semiconductor chip (102) comprising a first surface (104), a second surface (106) opposite to the first surface (104) and sidewalls (108), the semiconductor chip (102) comprising an active chip area;
   - a redistribution layer (110) comprising a first side (114), the first side (114) of the redistribution layer (110) facing the first surface (104) of the semiconductor chip (102);
   - an RF absorption layer (122) external to the active chip area, wherein the RF absorption layer (122) comprises a doped semiconductor material such that the dissipating factor of the RF absorption layer (122) is equal or greater than 0.1 in the operating frequency range.

2. The RF semiconductor device (100) according to claim 1, wherein the RF absorption layer (122) is disposed on the semiconductor chip (102) outside of the active chip area.

3. The RF semiconductor device (200) according to claim 1, further comprising a chip package (118) disposed over the second surface (106) of the semiconductor chip (102), wherein the chip package (118) comprises the RF absorption layer (122).

4. The RF semiconductor device (200) of claim 3, wherein the chip package (118) comprises in addition to the RF absorption layer (122) an encapsulation material (202), wherein sidewalls (108) of the semiconductor chip (102) and a part of the first side (114) of the redistribution layer (110) are encapsulated by the encapsulation material (202), wherein the encapsulation material (202) comprises a dissipating factor of less than 0.1 in the operating frequency range.

5. The RF semiconductor device (100) according to claim 1, wherein a plurality of solder balls (116) is arranged on a second side (112) of the redistribution layer (110) opposite to the first side (114) to mechanically and electrically connect the RF semiconductor device (100) to a printed circuit board.

6. The RF semiconductor device (100) according to claim 1, wherein the RF absorption layer (122) comprises a doped semiconductor filler material with a volume of at least 45%.

7. The RF semiconductor device (100) according to claim 6, wherein the RF absorption layer (122) comprises a polymer mold material with a volume of 55 % or less.

8. The RF semiconductor device (100) according to claim 6, wherein the doped semiconductor filler material comprises doped semiconductor particles, wherein the semiconductor filler material comprises:

   - a particle size of the doped semiconductor particle is less than 100 $\mu$m, wherein the semiconductor particles comprise at least one of p-doped crystal semiconductor particles, p-doped amorphous semiconductor particles or p-doped semiconductor oxide particles;
   - an electrical resistivity in a range of 1 to 100 ohm-cm; and
   - a real part of a relative permittivity is in range of 5 to 15.

9. The RF semiconductor device (500) according to claim 1, wherein the RF absorption layer (122) comprises:

   - a p-doped silicon layer, wherein an electrical resistivity of the p-doped layer is in range of 1 to100 ohm cm; and
   - a real-part of a relative permittivity is in a range of 5 to15.

10. The RF semiconductor device (200, 600) according to claim 1 to 9, wherein an encapsulation material (202) is arranged between the RF absorption layer (122) and the first side (114) of the redistribution layer (110), wherein the encapsulation material (202) covers and is in contact with the sidewalls (108) and second surface (106) of the semiconductor chip (102) and the first side (114) of the redistribution layer (110).

11. The RF semiconductor device (300, 700) according to claim 1 to 9, wherein the encapsulation material (202) covers and is in contact with the side walls (108) of the semiconductor chip (102) and the first side (114) of the redistribution layer (110), wherein the RF absorption layer (122) covers and is in contact with the second surface (106) of the semiconductor chip (102) and the encapsulation material (202) covering the first side (114) of the redistribution layer (110).

12. The RF semiconductor device (400) according to claim 1 to 9, wherein the RF absorption layer (122) covers and is in contact with the second surface (106) of the semiconductor chip (102), wherein the encapsulation material (202) covers and is in contact with the sidewalls (108) of the semiconductor chip (102), the first side (114) of the redistribution layer (110) and the RF absorption layer (122) covering the second surface (106) of the semiconductor chip (102).

13. The RF semiconductor device according to any preceding claim, wherein a metal plate (124) is attached to the chip package (118), at chip package (118)-air interface lateral to the second surface (106) of the semiconductor chip (102).

14. A method for fabricating a radio frequency (RF) semiconductor device to process RF signals in an operating frequency range comprises:

   - providing a semiconductor chip comprising a first surface, a second surface opposite to the first surface and sidewalls, the semiconductor chip comprising an active chip area;
   - providing a redistribution layer comprising a first side, the first side of the redistribution layer facing the first surface of the semiconductor chip;
   - disposing an RF absorption layer external to the active chip area, wherein the RF absorption layer comprises a doped semiconductor material such that the dissipating factor of the RF absorption layer is equal or greater than 0.1 in the operating frequency range.

100

124

122

108

110

114

112

116    102   104   106

Figure 1

200

204

124

206

122

118

108

202

110

114

112   116    102   104   106   206

Figure 2

300

124

122
120
118

108

110

114

112    116    102  104  106

Figure 3

400

124

122
120
118

108

110

114

112    116    102  104  106

Figure 4

Figure 5

Figure 6

700

124

502 } 504

108

120

110

114

112    116

102  104  106

Figure 7

Figure 8

Europäisches
Patentamt

European
Patent Office

Office européen
des brevets

**EUROPEAN SEARCH REPORT**

Application Number

EP 23 15 8383

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/022291 A1 (MATSUZAKI TORU [JP] ET AL) 16 January 2020 (2020-01-16) <br> * paragraph [0005]; figures 2, 7 * <br> * paragraph [0038] – paragraph [0040] * <br> * paragraph [0065] – paragraph [0067] * <br> ----- | 1,2,5, 13,14 | INV. <br> H01L23/552 <br> H01L23/31 <br> H01L23/36 |
| Y <br><br> A | US 2011/278736 A1 (LIN YAOJIAN [SG] ET AL) 17 November 2011 (2011-11-17) <br> * paragraph [0195] – paragraph [0197]; figure 22c * <br> ----- | 1-7,10, 11,14 <br> 8,9,12, 13 | |
| Y <br><br><br> E | CN 115 605 549 A (KYOCERA CORP) 13 January 2023 (2023-01-13) <br> * see D3' * <br> & US 2023/174774 A1 (UCHIDA KEN [JP] ET AL) 8 June 2023 (2023-06-08) <br> * paragraph [0012] – paragraph [0023]; figure 1; table 1 * <br> * paragraph [0030] * <br> * paragraph [0053] * <br> ----- | 1-6, 10-14 <br><br> 1-6, 10-14 | |
| Y | US 2019/279783 A1 (GHOSH DIPANKAR [US] ET AL) 12 September 2019 (2019-09-12) <br> * paragraph [0002] – paragraph [0003] * <br> * paragraph [0028] – paragraph [0030] * <br> * paragraph [0055] – paragraph [0072] * <br> ----- | 1-7, 10-14 | TECHNICAL FIELDS SEARCHED (IPC) <br><br> H01L |
| Y <br><br> A | US 2022/189892 A1 (BRENNER PIETRO [DE] ET AL) 16 June 2022 (2022-06-16) <br> * paragraph [0026] – paragraph [0050]; figures 4-6 * <br> ----- | 1-7, 10-14 <br> 8,9 | |
| A | US 2020/006371 A1 (HUO ZONGLIANG [CN] ET AL) 2 January 2020 (2020-01-02) <br> * paragraph [0051]; figure 1A * <br> ----- | 9 | |

-/--

The present search report has been drawn up for all claims

| Place of search | Date of completion of the search | Examiner |
|---|---|---|
| Munich | 11 August 2023 | Hirsch, Alexander |

EPO FORM 1503 03.82 (P04C01)

Europäisches Patentamt

European Patent Office

Office européen des brevets

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 0 940 848 A2 (IMEC INTER UNI MICRO ELECTR [BE]) 8 September 1999 (1999-09-08)<br>* paragraph [0002] – paragraph [0012] *<br>* paragraph [0029] – paragraph [0030] *<br>----- | 9 | |

**TECHNICAL FIELDS SEARCHED (IPC)**

The present search report has been drawn up for all claims

| Place of search | Date of completion of the search | Examiner |
|---|---|---|
| Munich | 11 August 2023 | Hirsch, Alexander |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 15 8383

This annex lists the patent family members relating to the patent documents cited in the above-mentioned European search report.
The members are as contained in the European Patent Office EDP file on
The European Patent Office is in no way liable for these particulars which are merely given for the purpose of information.

11-08-2023

| Patent document cited in search report | | | Publication date | Patent family member(s) | | Publication date |
|---|---|---|---|---|---|---|
| US 2020022291 | A1 | | 16-01-2020 | EP | 3595004 A1 | 15-01-2020 |
| | | | | JP | 2020009974 A | 16-01-2020 |
| | | | | US | 2020022291 A1 | 16-01-2020 |
| US 2011278736 | A1 | | 17-11-2011 | CN | 102637608 A | 15-08-2012 |
| | | | | SG | 183606 A1 | 27-09-2012 |
| | | | | SG | 10201403724P A | 30-10-2014 |
| | | | | TW | 201243970 A | 01-11-2012 |
| | | | | US | 2011278736 A1 | 17-11-2011 |
| | | | | US | 2015294962 A1 | 15-10-2015 |
| CN 115605549 | A | | 13-01-2023 | CN | 115605549 A | 13-01-2023 |
| | | | | EP | 4159816 A1 | 05-04-2023 |
| | | | | JP | WO2021241541 A1 | 02-12-2021 |
| | | | | KR | 20230008096 A | 13-01-2023 |
| | | | | TW | 202205561 A | 01-02-2022 |
| | | | | TW | 202243147 A | 01-11-2022 |
| | | | | US | 2023174774 A1 | 08-06-2023 |
| | | | | WO | 2021241541 A1 | 02-12-2021 |
| US 2019279783 | A1 | | 12-09-2019 | CN | 105009225 A | 28-10-2015 |
| | | | | EP | 2959490 A2 | 30-12-2015 |
| | | | | JP | 2016515298 A | 26-05-2016 |
| | | | | JP | 2019143149 A | 29-08-2019 |
| | | | | US | 2016019996 A1 | 21-01-2016 |
| | | | | US | 2017271040 A1 | 21-09-2017 |
| | | | | US | 2019279783 A1 | 12-09-2019 |
| | | | | WO | 2014130431 A2 | 28-08-2014 |
| US 2022189892 | A1 | | 16-06-2022 | CN | 114639661 A | 17-06-2022 |
| | | | | DE | 102020133756 A1 | 23-06-2022 |
| | | | | US | 2022189892 A1 | 16-06-2022 |
| US 2020006371 | A1 | | 02-01-2020 | CN | 109564923 A | 02-04-2019 |
| | | | | CN | 111430356 A | 17-07-2020 |
| | | | | JP | 6922108 B1 | 18-08-2021 |
| | | | | JP | 2021177573 A | 11-11-2021 |
| | | | | JP | 2021522696 A | 30-08-2021 |
| | | | | KR | 20200127260 A | 10-11-2020 |
| | | | | TW | 202002179 A | 01-01-2020 |
| | | | | US | 2020006371 A1 | 02-01-2020 |
| | | | | US | 2021104534 A1 | 08-04-2021 |
| | | | | US | 2021272976 A1 | 02-09-2021 |
| | | | | WO | 2020000318 A1 | 02-01-2020 |
| EP 0940848 | A2 | | 08-09-1999 | NONE | | |

EPO FORM P0459

For more details about this annex : see Official Journal of the European Patent Office, No. 12/82

## ANNEX TO THE EUROPEAN SEARCH REPORT
## ON EUROPEAN PATENT APPLICATION NO.

EP 23 15 8383

This annex lists the patent family members relating to the patent documents cited in the above-mentioned European search report.
The members are as contained in the European Patent Office EDP file on
The European Patent Office is in no way liable for these particulars which are merely given for the purpose of information.

11-08-2023

| Patent document cited in search report | Publication date | Patent family member(s) | Publication date |
|---|---|---|---|
| | | | |

For more details about this annex : see Official Journal of the European Patent Office, No. 12/82

EPO FORM P0459

page 2 of 2